# EUROPEAN PATENT APPLICATION

(11) **EP 2 660 612 A1**
(43) Date of publication of application: **06.11.2013**
(21) Application number: 11852805.8
(22) Date of filing: 29.12.2011
(51) Int. Cl.: G01R 21/133

(54) **DEVICE FOR LINKING AN ELECTRONIC ELECTRICITY METER TO A REMOTE USAGE DISPLAY**

(30) Priority: 29.12.2010 BR PI1005073
(71) Applicant: Light Serviços De Eletricidade S/A, CEP: 20080-002 Rio de Janeiro - RJ (BR); Cas Tecnologia S/A, CEP: 01310-200 São Paulo - SP (BR); Instituto de Tecnologia para o Desenvolvimento - LACTEC, CEP: 81531-980 Curitiba - PR (BR); Fundação Cpqd-Centro De Pesquisa E Desenvolvimento Em Telecomunicacoes, CEP: 13086-902 Campinas -SP (BR)
(72) Inventor: TOLEDO, Fábio de Oliveira, CEP: 20080-002 Rio de Janeiro - RJ (BR); JACOMETTI, Welson Régis, CEP: 01310-200 São Paulo - SP (BR); WOLANIUK, Giordano Bruno, CEP: 80630-240 Curitiba - PR (BR); MOGNON, Vilson Rodrigo, CEP: 81531-980 Curitiba - PR (BR); CARNEIRO, Maria Cláudia Cortez, CEP: 13086-902 Campinas - SP (BR); BAGAROLLI, Alexandre, CEP: 13086-902 Campinas - SP (BR)
(74) Representative: Bosch, Matthias
(86) International application number: PCT/BR2011/000501
(87) International publication number: WO 2012/088574

(57) **Abstract**

This invention relates to a device that links a digital electricity meter to a remote usage display, such that there is no possibility of operation error and, in 100% of the cases, a meter with remote display is installed, in which the logical association between the meter and display can be correctly implemented.

## Description

### APPLICATION FIELD

The present invention is related to digital electric energy measuring devices and to a digital remote usage display and, particularly, to a logic association between these two elements through a digital communication device by current modulation through a connecting extension of the consumer connection.

### BACKGROUND OF THE INVENTION

Electronic measuring devices with remote usage display are a reality and are already known in the state of art.

Generally, their usage takes place in situations wherein - due to some reason, the electronic energy measuring device is installed in a location which does not permit for consumers to have access to the display usage indicator installed and, as a result of rules defined by Regulatory Agencies, or also due to the convenience of showing the consumer his consumption figures, a remote usage display needs to be installed.

Remote consumption displays are generally related to the meters to which they are linked through data communication media, either through physical connections - such as optical fibers, through connections by data transmission over electromagnetical means, such as induced or radiated radio frequency.

As to data communication media between said meter and the remote usage display, this is being accomplished by electromagnetic means and there is a logical relationship provided between both, determining that data transmitted by the meter be adequately received by the display and vice-versa. This logic relationship determines, finally, that the meter applied to the usage unit (name assigned to an electric energy user by the electric energy distributing company) send their data correctly to the usage display, set up close to the corresponding usage unit and not to the installed display, for example, in the adjacent unit.

In order to determine this relationship, the current state of art foresees different forms of approach. In one of these approaches, meters and displays are being manufactured and their association is made in the factory, so that the pair (meter/display), once correctly installed (i.e. meter is installed at the initial stage of the connecting extension of a consumer and display is installed in the final section of the extension connecting the same consumer), data communication will be correctly established. In another approach, both meters and displays are associated in a logical manner by programmed parameters, utilizing tools such as computers, determining in a program to which meter belongs a given display and vice-versa.

In the event of an operational error during the process of association of a meter, equipped with a remote display unit, this error will, finally, cause an incorrect operation of said remote display, either because it is not receiving any data from the consumer meter, or due to presenting data which are from a meter which is not the unit installed for said consumer, resulting in losses and renewed labor costs for the electric energy distributing companies, who utilize this type of equipment, in addition to damages and discomforts to consumers. who needs the correct information for family planning.

### OBJECT OF THE INVENTION

The object of the present invention consists in providing a mechanism to associate an electric energy meter to a remote usage display, in such a manner that there will be no possibility for operational errors and in 100% of the cases, a meter with a remote usage display may be installed, in which the logical association between meter and remote usage display may be undertaken in a correct manner.

### BRIEF DESCRIPTION OF DRAWINGS

Fig. 1 features a diagram, representing a digital energy meter and a remote usage display, installed in the field in one of their possible embodiments.
Fig. 2 features the linking process of said remote usage display to said energy meter.
Fig. 3 features the operation of said meter already linked to the remote usage display.

### DETAILED DESCRIPTION OF THE INVENTION

The present invention relates to digital electric energy meters and remote digital displays and covers, particularly, the mechanism and the logical linking procedure between these two elements, so that there is no possibility of an operational error and that the procedure accomplished for this association evidences a much more reduced cost figure and complexity.

The usage of electrical energy by residences, trade and industries, is a feature of modern society, whose practice started over a hundred years ago. Electrical energy measuring by means of measuring devices is a practice which started almost at the same time. The first patents of invention related to electromechanical electrical energy measuring devices were requested by Gardiner (1872) and Fuller (1878) and, since that time, it has been common practice in all countries of the world to build electrical energy distributing networks, where, for each consumer, an electrical measuring meter is installed at the entrance of the residence or commercial or industrial premises, designed to record consumption figures of electrical energy used by consumer, with the purpose of enabling billing/invoicing procedures. Ever since their invention, electrical energy meters feature on their front panel information, permitting that consumption during a given period, for example, one month, be recorded by manual annotation procedures and by means of cyclic accounting procedures, featuring the amount to be charged to each consumer.

More recently, with the advent of electronics, electrical energy meters have become electronic units, avoiding the use of gears and analog displays I favor of the utilization of electronic circuits and digital displays to show data relative to consumption and demand of electrical energy.

With the introduction of electronic measuring devices, a host of problems associated to local installation of meters at the entrance of residences, began to be solved with installations of meters on posts, inside closed and sealed housings, or also in housings protected against natural disasters, such as floods. It is a known fact that in locations of seasonal flooding, the traditional installation of said meters close to the wall of the entrance of a residence implies in constant damages, with the destruction of the meters. Additionally, in areas where urban organization is precarious, where façades of homes are not of masonry, in occupied areas or, also, in areas where a constant change of residential structures takes place, and the electric energy distributing companies have made an option for installing said meters at posts close to the residences, in elevated and closed housings to provide shelter against weather action and the extension of the connection, which is a set of electrical wires, connecting said meter to the electric network, extends from these housings with the energy already duly measured, towards the residence of the consumer.

The requirement for information to consumers, as determined by regulations in force in each country or region and, in this case, of a mandatory nature in our country, as set forth by ANEEL *(Brazilian National Agency for Electrical Energy),* in the same fashion as occurs in other regions of the world, determining to electric energy distributing companies to install in addition to the electric energy measuring device, a remote usage display, so that the consumer, in his own residence, may comfortably verify his usage figures such as are being measured in the meter which is installed far away from his visual range.

It so happens that in the installation of a meter far from the consumer's visual range and of the remote display to meet demands of the regulations in force, there are operational procedures to be carried out. In all current operating procedures difficulties and complexities occur that affect the installation process and also provide results which cannot, in an assured manner, be easily validated, except in the case of actions demanding more time and financial costs.

Energy measuring generates information which will determine the amount to be invoiced to each consumer. It is imperative that consumers possess remote usage displays correctly reflecting the value measured, not only permit to accompany consumption figures by the consumers themselves, as well as verification of invoices received.

In this scenario, an electronic meter can be linked to consumer's display in a factory, in a lab of the electric energy distributing company (before being provided for installation in the consumer residence) or, also, in the field, during the specific installation procedure.

It so happens that all these approaches generate potential problems. First of all, linking in factory produces a pair- meter/display-which should necessarily be installed in a joint, interconnected, manner. This generates a host of problems: during the logistic process of storing and delivery of thousands of meters for installation, the distributor will have to insure maintenance of coupled pairs of meter/display or companies would have to develop other techniques to locate, for each meter, its respective linked display. In the installation process specifically, often installation of meters takes place before installation of display, since the electric network *per se* has to be created. With the installation, at a later date, of said displays, it would be required to check, in an indisputable manner that said display is actually linked to each consumer. Any error in this verification procedure, either by documentary procedures, or through visual observation in the housings of the meters, will imply in extra costs, in addition to the natural possibility of error- either in the information, or in the procedure different from the correct unit, by installing a display different, or not evidencing data to consumer (in the event of a wrong meter and its corresponding meter not having even been installed) or, also, featuring incorrect information (in the event display, for example, has been changed between adjacent residences). In both cases, damages will be occurring, both for the distributing company as well as for the consumer, In the event of a failure, for example of the remote display, linking procedures at the factory level will force distributing company to replace both the meter as well as the remote usage display, which will imply in a potentially more expensive correction of the failure (A).

The connection between a meter and display, accomplished previously In a monitored environment not specifically at the factory, but in a lab, for example, of the distributor, would partially solve the problem of cost figures in replacing faulty components, however will not resolve totally the problems pointed about under (A) and another problem will be added: the need of creating an overall logistic, involving persons, physical space and procedures which also will affect cost figures of the procedure, without considering that they could possibly introduce other errors to the procedure, such as consequences of a prior configuration which has taken place outside of the area of installation (B).

Overall flexibilization, permitting remote usage display to be configured at the exact moment in which it is effectively installed in the consumer residence, is the alternative which would settle, in the best manner, the problems pointed out in (A) and (B) if it were not for presently available means. This is an issue which is being solved with the present invention.

Usually, linking procedures between a meter and remote usage display imply in recording activities, consisting in configuration of one or more of the following: information provided to both equipment involved (meter/display): serial number of meter, informed to display, serial number of the display, informing to meter or also in a fashion more appropriate towards inducing errors, the serial number of both equipment to a third unit, in the event of an software based automation system, which, on its turn, will establish the logical link between the equipment.

Since this involves information that requires to be transmitted from one side to another side, usually even with the assistance of other electronic accessories, such as PCs, handheld computers, data collecting devices, amongst others, there is always a possibility of an error of annotation, errors of transmission, errors of observation (for example, observing a meter on a post and erroneously associating to a residence distant various meters between a set of small residences). The possibility of errors is high and its correction costs time, financial resources and generates dissatisfaction, again involving all parties and society (C).

Data transmission by current modulation is the title assigned to a set of electronic and computational techniques to permit digital data transmission. Modulation, in electronics, is the process of utilizing a variation of one or more properties of a wave - therefore named carrier wave, regarding a Modulated Signal. In the present invention, data transmission by current modulation will be utilized to link, in a biunivocal way, a remote usage display to a digital energy meter. A data transmitter pursuant to the current modulation technique (or even pursuant to any other technique) codifies and sends data. A data reception unit decodifies and receives said data.

The linking function is provided by a simple procedure, direct and free of potential errors. Considering an installed meter, be it at a post close to the residence, be it in a closed housing, there is a set of wires exiting this meter, extended towards the residence. Said wires interconnect the electrical network of the consumer residence and the simple fact that said wires are getting_interconnected and that they carry electrical energy, is sufficient to understand that, at the other side, there is a meter, notwithstanding what measure it is, its serial number or any other feature for the linking process.

This meter, installed for this residence, has a resource of being a receiver, so as to capture a data transmission by current modulation, originating from a transmitter. Said transmitter, in the present case, is the remote display itself, or, also, a tool temporarily connected with the remote display and which, by said wire leading to said display towards the energy meter, transmitting electrical energy through said wire, containing the information about which of the displays is to be linked.

By thus proceeding, there will be no doubt which display is being linked to the meter and both, from this stage on, will be able to use any other communication media to exchange data in a bidirectional manner, and there will be no requirement of a continuity in the data transmission by current modulation, utilized for the linking process.

In fact, the innovation applied in this patent of invention, particularly, its wisdom, is due to the fact that the energy meter is already a device dedicated to register current signals. Generally, it utilizes current information to measure electrical energy supply. In a linking process between a meter and a remote display according to this patent of invention, an electric energy meter will be equipped with its natural current sensor, in addition to the capability of recognizing and decodifying signals transmitted by current modulation. To render this process additionally safer, it will be carried out with extremely low currents, while the residence is, effectively, still without electric energy supply, so that supply will effectively have taken place - said linking will already have been made and consumer will be able - from the very onset of supply - to accompany data in his remote display.

The remote transmitter, on its turn, could be directly the transmitter, or, in the event of being economically more interesting, may utilize a tool used only during the Installation process to operate as a transmitter.

The present invention was conceived with the object of determining safer standards for distributing companies/concessionaires and consumers alike, concerning correct installation of digital electric energy meters and their association to remote usage displays. According to this object, the invention is subsequently being shown with a detailed description of each component, with reference to sheets of attached designs.

The present invention does not cover neither an electric energy meter, nor a remote usage display, however both are being jointly used and linked, so as to eliminate any possibility of a linking error, in addition to cutting down operational cost figures, associated with the installation process, activation and linking of this equipment, so as to materialize the object as exposed above in its entirety and in an absolute novel form.

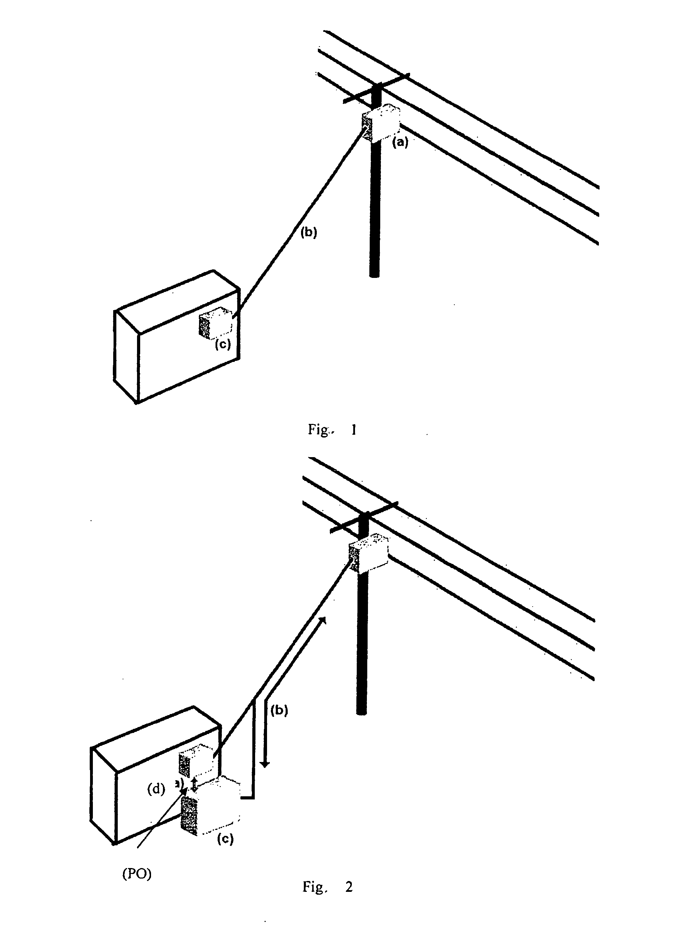

Fig. 1 features a diagram, representing a digital energy meter and a remote usage display installed in field, pursuant to one of their possible embodiments, containing meter installed on a post close to a residence (a), the consumer electric energy connecting extension (b) and the remote usage display, installed in an area adjacent of the consumer residence (c).

According to the present invention, the system that associates a digital electric energy meter to a remote usage display is composed of the following components:
- Digital electric energy meter (a);
- Connecting extension for consumer electric energy supply (b)- Remote usage display (c);
- Load monitor Unit (d) and
- Consumer Unit (not shown).

### Definitions:

Digital electric energy meter (a): a device composed of electronic circuits and digital displays to record and show data relative to consumption figures and demand of electric energy.

Connecting extension of electrical energy of Consumer Unit (b): set of electrical wires connecting meter to electrical net and measure until consumer Unit.

Remote usage display (c): device permitting that consumer in this consumer unit, may avail of the convenience of verifying his information concerning real consumption figures, such as they are being measured in the installed meter, far from his visual range.

Load control Unit (d): linking tool of remote usage display to digital electric energy meter, equipped with data transmission mechanism, for current modulation for data transmission.

Consumer Unit: physical consumer unit, corresponding to installation of a consumer.

Fig. 2 features the linking process of said remote usage display to a digital electric energy meter, considering linking procedure of display (a), current modulation procedure, accomplished by Load Control Unit and, furthermore, Load Control Unit accomplishing data transmission.

Pursuant to the system of the invention, the procedure to associate a digital electric energy meter to a remote usage display initiates as of the physical installation of the digital electric energy meter (a) corresponding to a Consumer Unit (not shown).

To carry out the logical association between said digital electric energy meter (a) and the corresponding remote usage display (c), said remote usage display (c) will be installed at the determined Consumer Unit.

Subsequently, said Load Control Unit (d) is physically connected to the extension of said electric energy link (b) determined, and through an optical gate (PO) to said corresponding remote usage display (c).

Said Load Control Unit (d) generates a current quantification for the digital electric energy meter (a) through a load switching feature, emitting a signal by current modulation and indicating to this meter that a Load Monitor Unit (d) is in place, associated to the extension of said electrical energy connection of the Consumer Unit (b).

On identifying this current modulation, associated to the extension of the electric energy connection of said Consumer Unit (b), the digital electronic meter (a) generates another signal to the Load Control Unit (d) either via radio, confirming recognition of the Load Control Unit (d).

By means of an optical connection, said Load Control Unit (d) reads and codifies the serial number of the remote usage display (C) and sends it to the digital electric energy meter (a) by means of a signal by current modulation. After receiving the serial number of said remote usage display (c), the digital electric energy meter (a) confirms reception through a radio signal to Load Control Unit (d).

Thus, a perfect logic association if established between the digital electric energy meter (a) and said remote usage display (c) and the procedure is then concluded without linking errors.

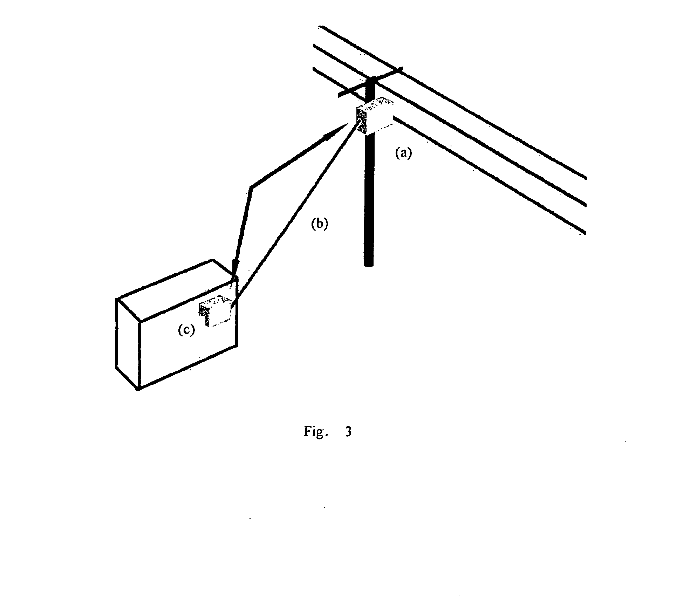

Fig.3 features the operation of said digital electric energy meter (a) already linked to remote usage display (c), evidencing transmission through any media which will be utilized by a data package of said meter (a), addressed to remote usage display (c) and its correct reception by display (c).

The mechanism and linking procedure of a remote usage display to a digital electric energy meter, as described in the present Patent of Invention, permit that linking be made directly by manufacturer in the factory, thus settling in a straightforward manner one of the issues addressed above (A).

Additionally, the fact that said field linking is being made in an absolutely safe manner, dispenses the need that linking be made in any other controlled environment, such as, for example, labs from the electric power distributing company, settling in a straightforward manner another of the issues as described above (B).

In the manner it was conceived, the present invention ,furthermore, assures that field linking accomplished will evidence, as a consequence, the correct association between the meter effectively applied to consumer and the remote usage display, furthermore permitting that the specialist who accomplishes this linking procedure, may assure that the residence and its registration with the electric energy distributing company are effectively correct, which, in any other situation, would be exactly the contrary (specialist would be depending upon recorded information to verify the correctness of a linking procedure undertaken) and this would determine the overall solution of all issues related to the procedure of linking said meter/display, with the extra benefit of generating the means, through which the distributor would get his recorded information possibly verified, completely settling said other problems, as described above (C).

In an absolutely Innovating manner, the present invention solves additionally a host of collateral problems, associated to the billing/invoicing process of electrical energy. Any consumer will have practical assurance that his display features effectively data sent by the meter applied to measuring his consumption. Thus, consumer may, in an equivalent form to the electric energy distributing company ,have a clear assurance that his invoicing/billing was actually originated through the meter installed in his residence or commercial or industrial establishment.

## Claims

1. Device for linking an electronic electricity meter to a remote usage display, **characterized in that** said device comprises:
- a digital electric energy meter (a) logically associated to a remote usage display (c) installed at a consumer unit;
- a load control unit (d), physically connected to the electric energy extension of said consumer unit (b), as determined by means of an optical gate (PO) to said corresponding remote usage display (c), accomplishing the logical association between the digital electronic meter (a) and the corresponding remote usage display (c);

2. Device, according to claim 1, **characterized in that** said load control unit (d) generates a current quantification for the digital electronic meter (a) through a switching of loads, sending a signal by means of current modulation and indicating to said meter that a load control (d) is available, associated to the electrical energy link extension of the consumer unit(b).

3. Device, according to claim 1, **characterized in that** said digital electric energy meter (a), on identifying this energy modulation associated to the electric energy linking extension of said consumer unit (b) generates another signal to said load control unit (d) via radio, confirming recognition of load control unit (d) load control unit (d).

4. Device, according to claim 1, **characterized in that** said load control unit (d), by means of an optical connection, reads and codifies the serial number of said remote usage display (e) and sending said data to the digital electric energy meter (a) via a radio signal by current modulation.

5. Device, according to claim 1, **characterized in that** after receiving the remote usage display (c) serial number, said digital electronic meter (a) confirms reception by means of a radio signal to said load control unit (d), establishing the perfect logic association between said digital electric energy meter (a) and the remote usage display (c)
